# DEMANDE DE BREVET EUROPEEN

(11) **EP 1 830 400 A1**
(43) Date de publication de la demande: **05.09.2007**
(21) Numéro de dépôt: 07354007.2
(22) Date de dépôt: 13.02.2007
(51) Int. Cl.: H01L 21/762

(54) **Procédé de fabrication d'un substrat par condensation germanium**

(30) Priorité: 01.03.2006 FR 0601850
(71) Demandeur: COMMISSARIAT A L'ENERGIE ATOMIQUE, 75015 Paris (FR)
(72) Inventeur: Damlencourt, Jean-François, 38120 Saint-Egrève (FR); Costa, Rémi, 05400 Veynes (FR)
(74) Mandataire: Jouvray, Marie-Andrée

(57) **Abrégé**

Le procédé de fabrication d'un substrat comprenant un composé de silicium et germanium sur isolant et de type Si_{1-Xf}Ge_{Xf}, avec Xf compris entre une première valeur non nulle et 1, comprend la formation d'une couche en alliage de silicium et germanium de type Si_{1-Xi}Ge_{Xi}, avec Xi compris strictement entre 0 et Xf, sur un substrat en silicium sur isolant. Le procédé comprend ensuite une première étape (Ox1) d'oxydation thermique du silicium de ladite couche à une première température d'oxydation (T1) prédéterminée, afin d'obtenir par condensation du germanium ledit composé de type Si_{1-Xf}Ge_{Xf}. La première étape (Ox1) d'oxydation thermique comporte au moins une étape (P2, P4) de traitement thermique sous gaz inerte à ladite première température d'oxydation (T1) prédéterminée. Le procédé peut comporter, par exemple, une deuxième étape (Ox2) d'oxydation thermique réalisée à une deuxième température d'oxydation (T2) prédéterminée, distincte de la première température d'oxydation (T1) prédéterminée.

## Description

### Domaine technique de l'invention

L'invention concerne un procédé de fabrication d'un substrat comprenant un composé de silicium et germanium sur isolant et de type Si_{1-Xf}Ge_{Xh} avec Xf compris entre une première valeur non nulle et 1, comportant au moins :
- la formation d'une couche en alliage de silicium et germanium de type Si₁₋ₓᵢGeₓᵢ, avec Xi compris strictement entre 0 et Xf, sur un substrat en silicium sur isolant,
- une première étape d'oxydation thermique du silicium de ladite couche à une première température d'oxydation prédéterminée, afin d'obtenir par condensation du germanium ledit composé de type Si_{1-xf}Ge_{xf}.

### État de la technique

La technologie microélectronique actuelle, basée sur le silicium, arrive aux limites des possibilités offertes par ce matériau. Les besoins croissants en dispositifs électroniques toujours plus performants, plus rapides et plus économes en énergie ont conduit à étudier de nouvelles solutions.

L'industrie microélectronique s'est alors tournée vers le germanium, qui est entièrement compatible avec la technologie développée pour le silicium et qui présente la même structure cristalline que le silicium, mais avec des meilleures propriétés notamment en termes de mobilité de porteurs de charge.

Une application particulière concerne les transistors à effet de champ semiconducteur oxyde métallique de type p (pMOSFET : « metal-oxyde-semiconductor field-effect transistor). L'article « Selectively-formed high mobility SiGe-On-Insulator pMOSFETs with Ge-rich strained surface channels using local condensation technique » de T. Tezuka et al. (2004 IEEE Symposium on VLSI Technology Digest of technical papers) décrit notamment la réalisation d'un pMOSFET, dont l'amélioration des performances est particulièrement sensible pour des transistors appauvris en porteurs de charge (FD pMOSFET) réalisés en germanium.

Pour la fabrication de substrats en germanium sur isolant (GOI ou GeOI : « Germanium On Insulator), une première technique utilise la technologie « Smart Cut » (marque déposée), initialement développée pour la fabrication de substrats en silicium sur isolant (SOI: « Silicon On Insulator »), décrite notamment dans l'article « 200mm Germanium-On-Insulator (GeOI) structures realized from epitaxial wafers using the Smart Cut™ technology » de C. Deguet et al. (Proceedings ECS 2005, Québec). Cette technologie est basée sur le report, sur un substrat en silicium, d'une couche de germanium, déposée sur une couche d'oxyde de silicium formant une couche isolante. Le substrat en GOI ainsi obtenu est du type pleine plaque. Cependant, cette technologie présente un coût très élevé et des transistors de type nMOSFET sont très difficiles à réaliser.

Une deuxième technologie est basée sur le principe de la recristallisation latérale, notamment décrit dans l'article « High-quality single-crystal Ge on insulator by liquid-phase epitaxy on Si substrates » de Y. Liu et al. (Applied Physics Letters, vol.84, n°14, April 5, 2004), permettant de réaliser un substrat en GOI du type localisé. La technique consiste à déposer localement sur un substrat standard en silicium une couche de nitrure, qui formera l'isolant, puis ensuite à déposer au-dessus une couche plus étendue de germanium, qui sera alors localement en contact avec le substrat en silicium. Une fois encapsulé, l'empilement est chauffé brièvement à la température de fusion du germanium puis refroidi. La solidification du germanium fondu s'amorce sur le silicium du substrat (germe monocristallin), puis le front se propage formant localement une couche de germanium monocristalline sur isolant. Cependant, cette technique de réalisation de substrat en GOI localisé est lourde, du fait des problèmes de stabilité d'interfaces, et la recristallisation est limitée à la fois en étendue et en géométrie.

Une troisième technique de fabrication connue utilise la technique de condensation germanium, permettant également de réaliser des substrats en GOI localisés. Cette technique repose sur la miscibilité totale du germanium et du silicium (même structure cristalline) et sur la différence d'affinités chimiques entre le germanium et le silicium vis-à-vis de l'oxygène, notamment mises en évidence dans l'article « A novel Fabrication Technique of Ultrathin and Relaxed SiGe Buffer Layers with High Ge Fraction for Sub-100nm Strained Silicon-On-Insulator MOSFETs » de T. Tezuka et al. (Jpn. J. Appl. Phys. Vol. 40 (2001) pp.2866-2874 Part1, No. 4B, April 2001).

L'article « Characterization of 7-nm-thick strained Ge-on-insulator layer fabricated by Ge-condensation technique » de S. Nakaharai et al. (Applied Physics Letters, vol. 83, n°17, October 27, 2003) décrit notamment le principe de fabrication d'un substrat par condensation germanium.

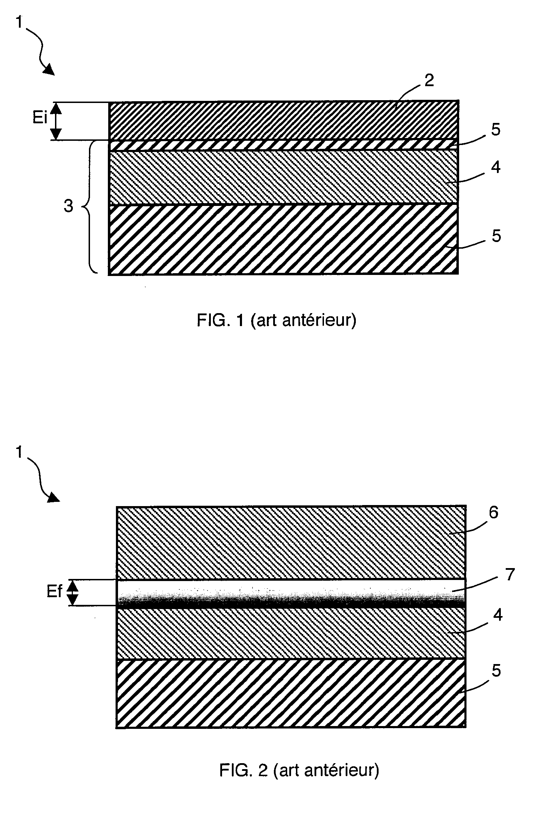

Comme représenté schématiquement sur les figures 1 et 2, la fabrication d'un substrat 1 comprenant un composé de silicium et germanium sur isolant et de type Si_{1-Xf}Ge_{Xf}, avec une concentration finale Xf de germanium comprise entre une première valeur non nulle et 1, comporte la formation d'une couche 2 en alliage de silicium et germanium de type Si_{1-Xi}Ge_{Xi}, avec une concentration initiale Xi de germanium comprise strictement entre 0 et Xf. La couche 2 en Si_{1-Xi},Ge_{Xi}, est déposée sur un substrat 3 en SOI comportant une couche 4 d'oxyde de silicium SiO₂, enterrée entre deux couches 5 de silicium et formant un isolant pour le substrat 3 en SOI (figure 1).

Puis, la seconde étape consiste à réaliser un traitement d'oxydation thermique, de préférence à haute température, du silicium de la couche 2 en Si_{1-Xi}Ge_{Xi}. Le silicium ayant une meilleure affinité chimique envers l'oxygène, le germanium n'est pas oxydé. Comme représenté sur la figure 2, l'oxydation thermique entraîne alors la consommation du silicium de l'ensemble de l'empilement du substrat 3 en SOI et de la couche 2 en Si₁₋ₓᵢGeₓᵢ, pour former une couche supérieure 6 de SiO₂, disposée sur le dessus du substrat 1. La couche 5 de silicium disposée initialement entre la couche 2 en Si₁₋ₓGeₓᵢ et la couche 4 de SiO₂ enterrée a été consommée pendant l'oxydation thermique et est remontée dans la couche supérieure 6 en SiO₂.

Sur la figure 2, le germanium n'étant pas soluble dans le SiO₂, une couche 7 enrichie en germanium, formant le composé en Si_{1-xf}Geₓₕ a été rejetée contre la couche 4 de SiO₂ enterrée et présente une épaisseur finale Ef, inférieure à l'épaisseur initiale Ei de la couche 2 en Si₁₋ₓᵢGeₓᵢ.

Comme décrit dans l'article « Oxidation of Si1-xGex alloys at atmospheric and elevated pressure » de D.C. Paine et al. (J. Appl. Phys. 70(9), November 1, 1991), le procédé de condensation germanium peut se poursuivre jusqu'à la consommation complète du silicium, de manière à obtenir une couche 7 comprenant exclusivement du germanium, pour former un composé en GOI, avec une concentration finale Xf de germanium égale à 1. Dans le cas où le silicium n'est pas complètement consommé, la couche 7 forme alors un composé en SGOI avec une concentration finale Xf de germanium comprise strictement entre 0 et 1.

Cependant, un problème majeur de cette technique de condensation germanium, pour la fabrication d'un substrat 1 comprenant un composé en Si_{1-Xf}Ge_{Xf}, est la relaxation des contraintes dans la couche finale 7 enrichie en germanium. Lors de l'oxydation de la couche 2 en Si_{1-Xi}Ge_{Xi}, il y a compétition entre oxydation du silicium et diffusion du germanium. Un fort gradient de composition peut conduire à un état de contrainte locale, telle que la couche 7 se relaxe plastiquement. Il en résulte alors l'apparition de réseaux croisés de dislocation dans la couche 7, engendrant notamment une mauvaise qualité du substrat 1.

Par ailleurs, l'article « Relaxed silicon-germanium-on-insulator fabricated by oxygen implantation and oxidation-enhanced annealing » de Zhijun et al. (Semiconductor Science and Technology IOP Publishing UK) décrit un autre procédé de réalisation d'un substrat en SGOI, comportant une étape de dépôt d'une couche en Si₁₋ₓGeₓ sur un substrat en silicium, suivie d'une étape d'implantation ionique et d'une étape d'oxydation thermique à une température de 1000°C sous oxygène pur. Puis, le procédé comporte une étape de traitement thermique de recuit à l'argon, combiné avec 1% d'oxygène, à haute température, de l'ordre de 1300°C. Cependant, un tel procédé de réalisation s'avère, d'une part, difficile à mettre en oeuvre et, d'autre part, ne permet pas l'obtention d'un substrat 1 de bonne qualité.

### Objet de l'invention

L'invention a pour but de remédier à l'ensemble des inconvénients précités et a pour objet un procédé de fabrication d'un substrat comprenant un composé de silicium et germanium sur isolant et de type Si_{1-Xf}Ge_{Xh} qui soit facile à mettre en oeuvre et qui présente des caractéristiques optimales en termes de concentration de germanium.

Selon l'invention, ce but est atteint par les revendications annexées et, plus particulièrement, par le fait que la première étape d'oxydation thermique comporte au moins une étape de traitement thermique sous gaz inerte à ladite première température d'oxydation prédéterminée.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
Les figures 1 et 2 représentent schématiquement deux étapes successives d'un procédé de fabrication d'un substrat selon l'art antérieur.
La figure 3 est un graphique représentant la température en fonction du temps, pour un procédé de fabrication d'un substrat selon l'invention.
La figure 4 est un graphique représentant la température en fonction du temps, pour une variante de réalisation d'un procédé de fabrication d'un substrat selon l'invention.
La figure 5 représente une étape d'une autre variante de réalisation d'un procédé de fabrication d'un substrat selon l'invention.

### Description de modes particuliers de réalisation

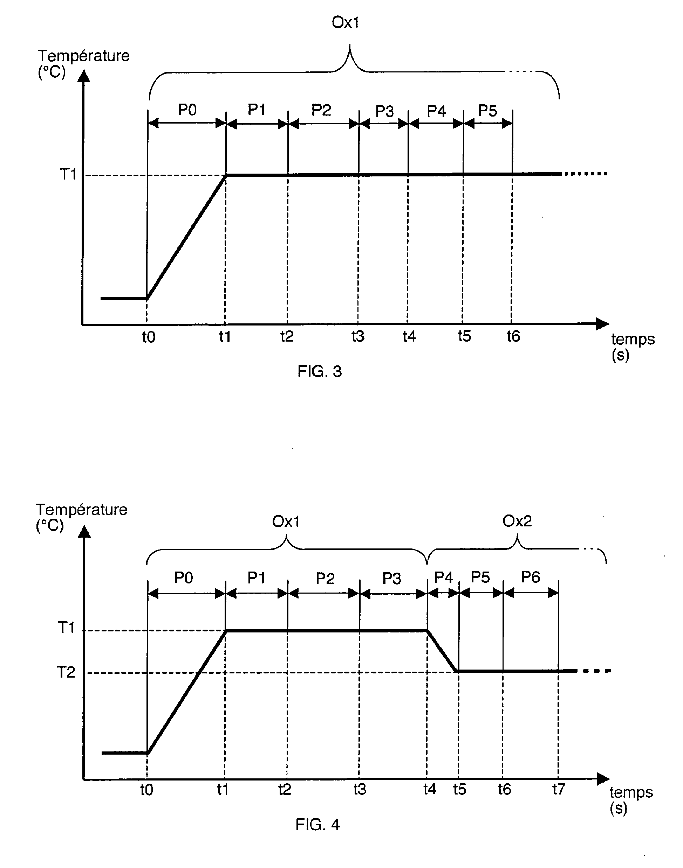

En référence aux figures 3 à 5, le procédé de fabrication est destiné à réaliser un substrat 1 en silicium et germanium sur isolant (SGOI) ou en germanium sur isolant (GOI), à savoir comprenant un composé de silicium et germanium sur isolant et de type Si_{1-Xf}Ge_{Xf}. La concentration final Xf de germanium est comprise strictement entre 0 et 1, pour un substrat en SGOI, et la concentration finale Xf de germanium est égale à 1, pour un substrat en GOI.

Le procédé de fabrication comporte d'abord la formation du substrat sur isolant 3 et la formation, par exemple par épitaxie, de la couche 2 en alliage de silicium et germanium de type Si₁₋ₓᵢGeₓᵢ (figure 1). Le procédé comporte ensuite un traitement d'oxydation thermique du silicium, réalisé, de préférence, à haute température et consistant notamment à injecter un gaz oxydant à l'intérieur, par exemple, d'une enceinte, dans laquelle est réalisé le procédé de fabrication du substrat 1.

Sur la figure 3, une première étape Ox1 d'oxydation thermique du silicium de la couche 2 comporte une étape préalable P0 de montée en température, entre les instants t0 et t1, réalisée sous gaz inerte, par exemple de l'azote, de l'hélium ou de l'argon, sous oxygène ou sous un mélange d'oxygène et de gaz inerte. L'étape préalable P0 permet d'atteindre la première température d'oxydation T1 prédéterminée, laquelle est, de préférence, inférieure à la température de fusion de l'alliage de silicium et germanium de la couche 2 en Si₁₋ₓᵢGeₓᵢ.

La première étape Ox1 d'oxydation thermique comporte ensuite une première période P1 d'oxydation thermique à la température T1, entre les instants t1 et t2, suivie par une première période P2 de traitement thermique sous gaz inerte, entre les instants t2 et t3, réalisée à la même température, à savoir à la première température d'oxydation T1 prédéterminée. Par gaz inerte, on entend un gaz inerte pur, c'est-à-dire un gaz inactif ne réagissant pas avec les composés des couches du substrat, plus particulièrement un gaz comportant 0% d'oxygène.

L'étape de traitement thermique sous gaz inerte, par exemple de l'azote, consiste à stopper l'injection de gaz oxydant, participant à l'étape d'oxydation, et injecter du gaz inerte pur à la place du gaz oxydant, pendant une durée prédéterminée et à la même température que pour l'oxydation.

L'injection de gaz inerte à la température T1 prédéterminée, pendant une durée prédéfinie, permet notamment la diffusion et l'homogénéisation de la concentration de germanium dans la couche 7 en formation du substrat 1.

Dans le mode particulier de réalisation de la figure 3, une seconde période P3 d'oxydation thermique, entre les instants t3 et t4, est ensuite réalisée après la première période P2 de traitement thermique sous gaz inerte, à la première température d'oxydation T1 prédéterminée. Puis, une seconde période P4 de traitement thermique sous gaz inerte est réalisée, entre les instants t4 et t5, comme décrit précédemment. Une troisième période P5 d'oxydation thermique, entre les instants t5 et t6, est ensuite réalisée à la suite de la deuxième période P4 de traitement thermique sous gaz inerte.

La première étape Ox1 d'oxydation thermique entrecoupée par plusieurs périodes de traitement thermique sous gaz inerte pur s'effectue ainsi de suite, tant que la concentration finale recherchée Xf de germanium reste inférieure à la concentration conduisant à la fusion de l'alliage de silicium et germanium à la première température d'oxydation T1 prédéterminée.

D'une façon générale, l'épaisseur initiale Ei de la couche 2 en Si_{1-Xi}Ge_{Xi} est choisie en fonction de l'épaisseur finale Ef souhaitée de la couche 7 en Si_{1-Xf}Ge_{Xf'} Plus l'épaisseur initiale Ei est épaisse, plus l'épaisseur finale Ef sera épaisse, l'épaisseur initiale Ei de la couche 2 en Si_{1-Xi}Ge_{Xi} devant être toujours inférieure à l'épaisseur critique de relaxation plastique. Par ailleurs, l'épaisseur finale Ef recherchée de la couche 7 en Si_{1-Xf}Ge_{Xf} dépend également de la vitesse d'enrichissement, la concentration finale Xf étant atteinte plus rapidement si la concentration initiale Xi est importante.

À titre d'exemple, la première température d'oxydation T1 prédéterminée est de l'ordre de 900°C à 1200°C, et est comprise, de préférence, entre 1025°C et 1075 °C. L'épaisseur initiale Ei de la couche 2 en Si₁₋ₓᵢGeₓᵢ est de l'ordre de 100nm, de l'ordre de 50nm ou de l'ordre de 30nm et la concentration initiale Xi de germanium de la couche 2 en Si₁₋ₓᵢGeₓᵢ est, respectivement, de l'ordre de 10%, de l'ordre de 20% ou de l'ordre de 30%.

Dans un mode particulier de réalisation, en partant d'une couche initiale 2 en Si_{1-Xi}Ge_{Xi} d'épaisseur initiale Ei de l'ordre de 100nm, avec une concentration initiale Xi de germanium de l'ordre de 10%, une température T1 de l'ordre de 1050°C et pour obtenir une concentration finale recherchée Xf de germanium de la couche 7 en Si_{1-Xf}Ge_{Xf} de l'ordre de 55%, avec une épaisseur finale Ef de l'ordre de 18nm, la première étape Ox1 d'oxydation thermique comprend des périodes d'oxydation thermique de l'ordre de 15min, 87min et 86min, soit une durée totale de 188min, entrecoupée par trois étapes de traitement thermique sous gaz inerte pur de l'ordre de 120min chacune.

Le procédé de fabrication selon l'invention, avec la première étape Ox1 d'oxydation thermique entrecoupée par des périodes de traitement thermique sous gaz inerte, permet notamment d'obtenir une couche 7 enrichie en germanium d'épaisseur finale Ef inférieure à l'épaisseur initiale Ei de la couche 2 et permettant d'éviter en cours d'enrichissement la relaxation plastique des contraintes liées au gradient de concentration dans la couche 7 ainsi formée. Il en résulte un substrat 1 avec des qualités optimales en termes d'homogénéisation de la concentration de germanium.

Dans une variante de réalisation non représentée, une seule période de traitement sous gaz inerte peut être réalisée pendant la première étape Ox1 d'oxydation thermique. La période de traitement thermique sous gaz inerte pur présente alors une durée suffisante, permettant de consommer complètement le silicium de la couche 2 en Si_{1-Xj}Ge_{Xi}, d'atteindre la concentration finale recherchée Xf de germanium et d'homogénéiser la composition de la couche 7 en Si_{1-Xf}Ge_{Xf} ainsi formée (figure 2).

Dans une autre variante de réalisation, une période de traitement thermique sous gaz inerte pur peut être réalisée juste après la période préalable P0 de montée en température de la première étape Ox1 d'oxydation thermique. L'alternance entre les étapes de traitement thermique sous gaz inerte et les périodes d'oxydation thermique s'effectue alors comme précédemment, à la température d'oxydation T1 prédéterminée. Dans ce cas, les périodes P1, P3 et P5 sont des périodes de traitement thermique sous gaz inerte et les périodes P2, P4 sont des périodes d'oxydation thermique. Dans le cas où une seule période de traitement thermique sous gaz inerte pur est nécessaire, la première période de traitement, suivant la montée en température, est une période de traitement thermique sous gaz inerte et la première étape Ox1 d'oxydation thermique continue, sans être coupée par d'autres étapes de traitement thermique sous gaz inerte.

Dans la variante de réalisation représentée sur la figure 4, le traitement d'oxydation thermique comporte une deuxième étape Ox2 d'oxydation thermique, réalisée à une deuxième température d'oxydation T2 prédéterminée, juste après la première étape Ox1 d'oxydation thermique. La deuxième température d'oxydation T2 prédéterminée est inférieure à la température de fusion de l'alliage de Si₁₋ₓᵢGeₓᵢ et, par exemple, inférieure à la première température d'oxydation T1 prédéterminée.

Le traitement d'oxydation thermique comporte donc une première étape Ox1 d'oxydation thermique, par exemple avec l'étape préalable P0 de montée en température, entre les instants t0 et t1, et des périodes d'oxydation thermique P1, P3, respectivement entre les instants t1 et t2 et les instants t3 et t4, entrecoupées par une période P2 de traitement thermique sous gaz inerte, entre les instants t2 et t3.

Le traitement d'oxydation thermique comporte ensuite une deuxième étape Ox2 d'oxydation thermique comportant une période intermédiaire P4, par exemple, de baisse de la température, entre les instants t4 et t5, jusqu'à atteindre la deuxième température d'oxydation T2 prédéterminée. La deuxième étape Ox2 d'oxydation thermique comporte ensuite, par exemple, une première période P5 d'oxydation thermique, entre les instants t5 et t6, suivie par une période P6 de traitement thermique sous gaz inerte pur, entre les instants t6 et t7.

La deuxième étape Ox2 d'oxydation thermique continue ainsi de suite, avec des périodes d'oxydation thermique entrecoupées par des périodes de traitement thermique sous gaz inerte, tant que la concentration finale recherchée Xf de germanium dans la couche 7 en Si_{1-xf}Ge_{xf} n'est toujours pas atteinte.

À titre d'exemple, en considérant les mêmes couples de valeurs pour l'épaisseur initiale Ei et la concentration initiale Xi comme décrits pour la figure 3, et pour obtenir un bon compromis entre la vitesse d'oxydation du silicium et la vitesse de diffusion du germanium, la première température d'oxydation T1 prédéterminée est de l'ordre de 1050°C et la seconde température d'oxydation T2 prédéterminée est de l'ordre de 900°C. Ainsi à 1050°C, la concentration maximale de germanium que l'on peut obtenir est de 65%, pour éviter la fusion de l'alliage. Pour poursuivre le procédé de condensation germanium, il faut alors diminuer la température d'oxydation par exemple jusqu'à la valeur T2 de l'ordre de 900°C, ce qui permet l'obtention d'une couche 7 de germanium pur, la deuxième température d'oxydation T2 restant inférieure à la température de fusion du germanium pur.

Dans une autre variante de réalisation non représentée, le traitement d'oxydation thermique peut comporter plusieurs autres étapes d'oxydation thermique, après la deuxième étape Ox2 d'oxydation thermique, chacune entrecoupées d'une ou plusieurs étapes de traitement thermique sous gaz inerte pur. Les différentes étapes supplémentaires d'oxydation thermique sont alors effectuées, de préférence, à des températures d'oxydation prédéterminées distinctes des première T1 et deuxième T2 températures d'oxydation prédéterminées et, de préférence, avec des valeurs décroissantes. Il en résulte notamment la réalisation d'un substrat 1 avec une couche 7 en Si_{1-xf}Ge_{xf} présentant des caractéristiques optimales en termes d'homogénéisation de la concentration de germanium.

Dans une autre variante de réalisation, le procédé de fabrication du substrat 1 peut comporter un traitement d'oxydation thermique à basse température, permettant d'éviter la consommation de germanium lors des différentes étapes du procédé de condensation germanium. À titre d'exemple, le traitement d'oxydation thermique à basse température est réalisé à une température comprise, par exemple, entre 700°C et 900°C et, de préférence, au début du procédé de condensation germanium.

Par ailleurs, l'étape d'oxydation basse température peut être effectuée quel que soit le nombre d'étapes d'oxydation thermique (figure 4) et quel que soit le nombre d'étapes de traitement sous gaz inerte (figures 3 et 4).

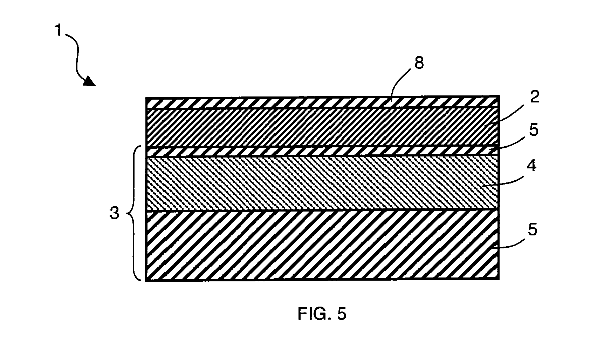

Sur la figure 5, la variante de réalisation du procédé de fabrication du substrat 1 se distingue des procédés de fabrication décrits précédemment par le dépôt d'une couche additionnelle 8 de silicium, formée sur la couche 2 en Si_{1-Xi}Ge_{Xi}, avant le traitement d'oxydation thermique pour former la couche 7 en Si_{1-Xf}Ge_{Xf}. La couche additionnelle 8 a une épaisseur, par exemple, de l'ordre de quelques angströms à quelques nanomètres et permet notamment de former une fine couche de SiO₂ sur le dessus du substrat 1, empêchant la consommation de germanium lors des premières périodes d'oxydation thermique.

Quel que soit le mode de réalisation du procédé de fabrication du substrat 1 décrit ci-dessus, un tel procédé permet notamment de fabriquer un substrat en GOI ou un substrat en SGOI présentant des caractéristiques optimales en termes de concentration de germanium, afin d'éviter tout problème dû à la relaxation des contraintes à l'intérieur de la couche 7 formée par condensation germanium. Par ailleurs, un tel procédé de fabrication peut être mis en oeuvre quelle que soit l'épaisseur souhaitée du substrat 1 et des couches 2 en Si₁₋ₓᵢGeₓᵢ et 7 en Si_{1-xf}Ge_{xf}.

L'invention n'est pas limitée aux différents modes de réalisation décrits ci-dessus. Les valeurs des concentrations de germanium, des durées de traitement et des épaisseurs de couches sont non limitatives et dépendent des caractéristiques initiales et finales souhaitées du substrat 1. Il est possible de réaliser une courbe de calibration permettant de définir rapidement les différentes valeurs des périodes de traitement et de concentration finale recherchée de germanium, en fonction notamment des températures d'oxydation prédéterminées.

Pour les étapes de traitement thermique sous gaz inerte pur, l'azote peut être remplacé par tout gaz inerte pur, par exemple, par l'argon, l'hélium, l'hydrogène ou un mélange d'hydrogène et d'azote.

Sur la figure 4, la deuxième température d'oxydation T2 prédéterminée peut être supérieure à la première température d'oxydation T1 prédéterminée, tant qu'elle reste inférieure à la température de fusion de l'alliage en Si₁₋ₓᵢGeₓᵢ de la couche 2. La première étape Ox1 d'oxydation thermique peut comporter des périodes supplémentaire d'oxydation thermique (non représentées), entrecoupées par des périodes supplémentaires de traitement thermique sous gaz inerte (non représentées).

Par ailleurs, dans le mode particulier de réalisation de la figure 4, la période P5 de la deuxième étape Ox2 d'oxydation thermique peut être une période de traitement thermique sous gaz inerte et la période P6 peut être une période d'oxydation thermique. De plus, la deuxième étape Ox2 d'oxydation thermique peut être entrecoupée d'une étape de traitement thermique sous gaz inerte ou de plusieurs étapes de traitement thermique sous gaz inerte.

## Revendications

1. Procédé de fabrication d'un substrat (1) comprenant un composé (7) de silicium et germanium sur isolant et de type Si_{1-Xf}Ge_{Xf}, avec Xf compris entre une première valeur non nulle et 1, comportant au moins :
- la formation d'une couche (2) en alliage de silicium et germanium de type Si_{1-Xi}Ge_{Xi}, avec Xi compris strictement entre 0 et Xf, sur un substrat (3) en silicium sur isolant,
- une première étape (Ox1) d'oxydation thermique du silicium de ladite couche (2) à une première température d'oxydation (T1) prédéterminée, afin d'obtenir par condensation du germanium ledit composé (7) de type Si_{1-Xf}Ge_{Xf},
procédé **caractérisé en ce que** la première étape (Ox1) d'oxydation thermique comporte au moins une étape de traitement thermique sous gaz inerte à ladite première température d'oxydation (T1) prédéterminée.

2. Procédé selon la revendication 1, **caractérisé en ce que** l'étape de formation d'une couche (2) en alliage de silicium et germanium de type Si₁₋ₓᵢGeₓᵢ est suivie par une étape de formation d'une couche additionnelle (8) de silicium.

3. Procédé selon l'une des revendications 1 et 2, **caractérisé en ce que** la première étape (Ox1) d'oxydation thermique comporte une étape préalable (P0) de montée en température sous atmosphère inerte ou oxydante, jusqu'à atteindre ladite première température d'oxydation (T1) prédéterminée.

4. Procédé selon l'une quelconque des revendications 1 à 3, **caractérisé en ce que** la première étape (Ox1) d'oxydation thermique comporte une pluralité d'étapes (P2, P4) de traitement thermique sous gaz inerte.

5. Procédé selon l'une quelconque des revendications 1 à 4, **caractérisé en ce que** la première température d'oxydation (T1) prédéterminée est inférieure à la température de fusion de l'alliage de silicium et germanium de type Si₁₋ₓᵢGeₓᵢ.

6. Procédé selon l'une quelconque des revendications 1 à 5, **caractérisé en ce qu'**il comporte au moins une deuxième étape (Ox2) d'oxydation thermique réalisée à une deuxième température d'oxydation (T2) prédéterminée, distincte de la première température d'oxydation (T1) prédéterminée.

7. Procédé selon la revendication 6, **caractérisé en ce que** la deuxième étape (Ox2) d'oxydation thermique comporte au moins une étape de traitement thermique sous gaz inerte, à ladite deuxième température d'oxydation (T2) prédéterminée.

8. Procédé selon l'une des revendications 6 et 7, **caractérisé en ce que** la deuxième température d'oxydation (T2) prédéterminée est inférieure à la température de fusion de l'alliage de silicium et germanium de type Si_{1-Xi}Ge_{Xi}.

9. Procédé selon l'une quelconque des revendications 6 à 8, **caractérisé en ce que** la première température d'oxydation (T1) prédéterminée est de l'ordre de 1025°C à 1075°C et la deuxième température d'oxydation (T2) prédéterminée est de l'ordre de 900°C.

10. Procédé selon l'une quelconque des revendications 1 à 9, **caractérisé en ce qu'**il comporte une étape d'oxydation basse température.

11. Procédé selon l'une quelconque des revendications 1 à 10, **caractérisé en ce que** l'épaisseur finale (Ef) de la couche (7) du composé de silicium et de germanium sur isolant et de type Si_{1-Xf}Ge_{Xf}, obtenue par condensation du germanium, est inférieure à l'épaisseur initiale (Ei) de la couche (2) de l'alliage de silicium et germanium de type Si_{1-Xi}Ge_{Xi}, déposée sur le substrat sur isolant (3).

12. Procédé selon la revendication 11, **caractérisé en ce que**, pour obtenir une concentration finale de germanium (Xf) de l'ordre de 55%, l'épaisseur initiale (Ei) est de l'ordre de 100nm, 50nm ou 30nm et la concentration initiale (Xi) est, respectivement, de l'ordre de 10%, 20% ou 30%.

13. Procédé selon la revendication 12, **caractérisé en ce que**, avec une épaisseur initiale (Ei) de l'ordre de 100nm et une concentration initiale (Xi) de l'ordre de 10%, pour obtenir une concentration finale (Xf) de l'ordre de 55%, la première étape (Ox1) d'oxydation thermique a une durée totale de l'ordre de 188min, entrecoupée par trois périodes de traitement thermique sous gaz inerte de l'ordre de 120min chacune.

14. Procédé selon l'une quelconque des revendications 1 à 13, **caractérisé en ce que** le gaz inerte est choisi parmi l'azote, l'argon, l'hélium, l'hydrogène ou un mélange d'hydrogène et d'azote.
